# EUROPEAN PATENT SPECIFICATION

(11) **EP 4 625 059 B1**
(45) Date of publication and mention of the grant of the patent: **16.09.2026**
(21) Application number: 25162241.1
(22) Date of filing: 07.03.2025
(51) Int. Cl.: G03G 15/04

(54) **IMAGE-FORMING APPARATUS**
BILDERZEUGUNGSGERÄT
APPAREIL DE FORMATION D'IMAGES

(30) Priority: 29.03.2024 JP 2024055718
(43) Date of publication of application: 01.10.2025
(73) Proprietor: CANON KABUSHIKI KAISHA, Tokyo 146-8501 (JP)
(72) Inventor: ITO, Kentaro, Tokyo, 146-8501 (JP); IWAWAKI, Hironobu, Tokyo, 146-8501 (JP)
(74) Representative: TBK

(56) References cited:
- US-A1- 2023 292 546
- US-B2- 10 854 821

## Description

### Field of the Invention

The present disclosure relates to an image-forming apparatus.

### Description of the Related Art

An electrophotographic image-forming apparatus forms an image by exposing a photosensitive member (hereinafter also referred to as a "drum-shaped electrophotographic photosensitive member" or a "photosensitive drum") to light at a controlled position. Such an image-forming apparatus is widely used as a printer. The image-forming apparatus includes an exposure portion including a light-emitting portion. Light-emitting elements known to be included in the exposure portion include a light-emitting diode (LED), an organic light-emitting diode (OLED), and a vertical-cavity surface-emitting laser (VCSEL). A photosensitive member is exposed to light emitted from these light-emitting elements, and an image corresponding to a latent image formed on the photosensitive member is printed on a recording medium, such as recording paper.

Japanese Patent Laid-Open No. 2022-100479 describes an image-forming apparatus including an organic light-emitting element in an exposure portion. An organic light emitting device is presented in patent literature US 10 854 821 B2. Patent literature US 2023/292546 A1 furthermore discloses a light-emitting element including a transmittance-increasing layer.

The image-forming apparatus described in Japanese Patent Laid-Open No. 2022-100479 has the exposure portion including the organic light-emitting element. The exposure portion has a so-called bottom emission configuration in which light emitted from the organic light-emitting element is emitted toward a photosensitive member through a transparent substrate. In the organic light-emitting element, a technique of increasing the emission intensity of a specific wavelength by using an optical resonator structure is known and can be applied to the exposure portion of the image-forming apparatus.

However, light emitted from an organic light-emitting element with an optical resonator structure is reflected between electrodes of the organic light-emitting element and passes through an organic layer multiple times, and light to be absorbed by a photosensitive member may therefore be absorbed by the organic layer of the organic light-emitting element.

### SUMMARY OF THE INVENTION

The present disclosure has been made in view of the above problems and provides an image-forming apparatus with high image formation efficiency.

The present disclosure in its first aspect provides an image-forming apparatus as specified in claims 1 to 15.

Further features of the present invention will become apparent from the following description of exemplary embodiments with reference to the attached drawings.

### BRIEF DESCRIPTION OF THE DRAWINGS

Figs. 1A to 1C are an emission spectrum of an organic light-emitting element according to an embodiment of the present disclosure, an optical absorption spectrum of an organic layer in the organic light-emitting element, and an optical absorption spectrum of a photosensitive member.
Figs. 2A to 2C are an emission spectrum of an organic light-emitting element according to an embodiment of the present disclosure, an optical absorption spectrum of an organic layer in the organic light-emitting element, and an optical absorption spectrum of a photosensitive member.
Fig. 3 is a schematic cross-sectional view of an organic light-emitting element according to an embodiment of the present disclosure.
Figs. 4A to 4C are schematic views of an image-forming apparatus according to an embodiment of the present disclosure.
Fig. 5 is a schematic view of an exposure portion according to an embodiment of the present disclosure.
Figs. 6A to 6C are schematic views of an exposure portion according to an embodiment of the present disclosure.

### DESCRIPTION OF THE EMBODIMENTS

An image-forming apparatus according to an embodiment of the present disclosure includes a light source including an organic light-emitting element on a first surface of a substrate; and a photosensitive member configured to receive light from the organic light-emitting element, wherein the organic light-emitting element includes a first electrode, a first organic compound layer, a light-emitting layer, a second organic compound layer, and a second electrode in this order from the first surface, and a maximum emission peak wavelength in an emission spectrum of the organic light-emitting element is closer to a wavelength of a maximum absorption value in a visible light region of an optical absorption spectrum of the photosensitive member than a longest peak wavelength in an optical absorption spectrum of the first organic compound layer or a longest peak wavelength in an optical absorption spectrum of the second organic compound layer.

The wavelength of the maximum emission peak in an emission spectrum of an organic light-emitting element according to the present embodiment is closer to the wavelength of the maximum absorption value in the visible light region of the photosensitive member of the image-forming apparatus than the wavelength of the longest-wavelength peak in an optical absorption spectrum of an organic compound layer in the organic light-emitting element. Although the organic compound layer can also absorb light emitted from the organic light-emitting element, the configuration described above can increase the light emission absorbed by the photosensitive member. Thus, the configuration has high image formation efficiency. When the organic compound layer includes the first organic compound layer and the second organic compound layer, the maximum emission peak wavelength in an emission spectrum of the organic light-emitting element may be closer to the wavelength of the maximum absorption value in the visible light region of the photosensitive member of the image-forming apparatus than the wavelength of the longest-wavelength peak in an optical absorption spectrum of the first organic compound layer or the second organic compound layer.

At this time, the maximum emission peak wavelength in the emission spectrum of the organic light-emitting element can be closer to the wavelength of the maximum absorption value in the visible light region of the photosensitive member of the image-forming apparatus than the wavelength of the longest-wavelength peak in the optical absorption spectrum of the first organic compound layer and the second organic compound layer. This is because light emitted from the organic light-emitting element is more likely to be absorbed by the photosensitive member than by any of the organic compound layers, thus resulting in high image formation efficiency.

In one embodiment of the present disclosure, the longest-wavelength peak is taken into consideration in energy transfer. This is because, when energy transfer follows the Foerster mechanism, the amount of energy transfer is estimated in proportion to the fourth power of the wavelength.

An organic light-emitting element according to an embodiment of the present disclosure includes a first electrode, a second electrode, and an organic compound layer disposed between the first electrode and the second electrode, and an electric charge is supplied from these electrodes to emit light. The organic compound layer may be composed of a plurality of layers and, more specifically, may include a hole injection layer, a hole transport layer, a light-emitting layer, an electron transport layer, and an electron injection layer. Each layer may be further divided into a plurality of layers. For example, the hole transport layer may include a first hole transport layer and a second hole transport layer. Furthermore, the name of each layer may be changed depending on its role. For example, when the electron transport layer has a role of reducing hole leakage from the light-emitting layer, the electron transport layer may be referred to as a hole-blocking layer. In the present specification, the first organic compound layer is provided between the first electrode and the light-emitting layer, and the second organic compound layer is provided between the light-emitting layer and the second electrode. A third organic compound layer may be provided between the first organic compound layer and the first electrode. A fourth organic compound layer may be provided between the second organic compound layer and the second electrode.

An organic light-emitting element according to an embodiment of the present disclosure may have a so-called top emission configuration in which the first electrode may be a reflective electrode and the second electrode may be a light extraction electrode. In the case of top emission, the second organic compound layer may have a larger thickness than the first organic compound layer. In this case, the longest-wavelength peak in the optical absorption spectrum of the second organic compound layer can be farther from the maximum emission peak wavelength in the emission spectrum than the longest-wavelength peak in the optical absorption spectrum of the first organic compound layer. An organic compound with a large layer thickness absorbs a large amount of light, and the optical absorption spectrum of the second organic compound layer with a large layer thickness can therefore be farther from the emission spectrum than the optical absorption spectrum of the first organic compound layer.

Likewise, when the first electrode is a reflective electrode and the second electrode is a light extraction electrode, the first organic compound may have a larger layer thickness than the second organic compound. In this case, the longest-wavelength peak in the optical absorption spectrum of the first organic compound layer can be farther from the maximum emission peak wavelength in the emission spectrum than the longest-wavelength peak in the optical absorption spectrum of the second organic compound layer. An organic compound with a large layer thickness absorbs a large amount of light, and the optical absorption spectrum of the first organic compound layer with a large layer thickness can therefore be farther from the emission spectrum than the optical absorption spectrum of the second organic compound layer.

In addition to the layer thickness, an optical absorption spectrum of an organic compound layer with a high optical absorption coefficient can be farther from the emission spectrum than an optical absorption spectrum of another organic compound layer.

In an organic light-emitting element according to an embodiment of the present disclosure, the first electrode and the second electrode may constitute an optical resonator structure. The optical resonator structure has a configuration in which the optical path length between the first electrode and the second electrode is a distance that strengthens light emitted from the light-emitting layer and increases the intensity of light emission at a specific wavelength. At least one of the first electrode and the second electrode is a reflective electrode, and the reflective electrode is an electrode that reflects at least part of incident light. The electrode may be a semitransparent electrode that transmits part of light. On the other hand, one of the first electrode and the second electrode is a light extraction electrode and is an electrode that transmits light. One of the first electrode and the second electrode may be a reflective electrode, and the other may be a semitransparent electrode.

Although an optical resonator structure constituted by an organic light-emitting element is based on the optical path length between the first electrode and the second electrode, it can also be obtained by considering a typical refractive index for the physical distance between the first electrode and the second electrode. For example, in the case of an organic compound layer, it can be estimated by multiplying the physical distance by 1.8. The typical refractive index may vary depending on the materials constituting the organic compound layer and the protective layer. The same applies to the formation of another optical interference.

In the optical resonator structure, for example, the optical path length between electrodes is configured to be the distance that strengthens light emitted from the light-emitting layer. For example, the distance from the light-emitting layer to the reflective layer on the substrate side is configured to be an odd multiple of λ/4. λ denotes the wavelength of light emitted from the light-emitting layer.

When production errors and the like are allowed, the optical path length L1 satisfies the following formula 1. The optical path length L1 may be the distance from the light-emitting layer to the reflective layer on the substrate side, the distance from the light-emitting layer to the reflective layer on the light extraction side, or the distance from the reflective layer on the substrate side to the reflective layer on the light extraction side. $0.7 \left(-Φ1/\left(2π\right)+m1\right) \times λ \leq 2 \times L 1 \leq 1.2 \left(-Φ1/\left(2π\right)+m1\right) \times λ$

λ denotes the wavelength of light emitted from the light-emitting layer, and Φ1 denotes the phase shift on the reflecting surface, and m1 is an integer. Φ1 is the sum of the phase shifts when there are two reflecting surfaces.

In an organic light-emitting element according to an embodiment of the present disclosure, when the first electrode is a reflective layer, optical interference may be formed between the first electrode and the light-emitting layer. Formation of optical interference refers to a configuration in which the distance between the first electrode and the light-emitting layer increases the intensity of light emission at a specific wavelength. The specific wavelength may be light emitted from the light-emitting layer. The same applies to another optical resonator structure or optical interference configuration.

When an organic light-emitting element according to an embodiment of the present disclosure includes, on a substrate, a reflective layer, a first electrode, an organic compound layer including a light-emitting layer, and a second electrode, optical interference may be formed between the reflective layer and the light-emitting layer. Optical interference may also be formed between the reflective layer and the second electrode. Either of them may be formed, or both of them may be satisfied at the same time. The same applies to another optical resonator structure or optical interference configuration.

An insulating layer may be provided between the reflective layer and the first electrode. The insulating layer may be a layer with an optical path length adjusted by its layer thickness. An electric conductor may be provided between the reflective layer and the first electrode. The electric conductor may be a layer with an optical path length adjusted by its layer thickness. An insulating layer can be provided between the reflective layer and the first electrode. The insulating layer can be composed of silicon oxide, silicon nitride, or the like.

An exposure portion of an image-forming apparatus according to an embodiment of the present disclosure includes a light-emitting element on a first surface of a substrate. The substrate may be a light-impermeable substrate, such as a silicon substrate. A transistor may be provided on a silicon substrate and may be coupled to an organic light-emitting element. The transistor controls the luminous brightness and timing of the organic light-emitting element.

The present disclosure is more specifically described with reference to embodiments. The embodiments may be combined.

### [First Embodiment]

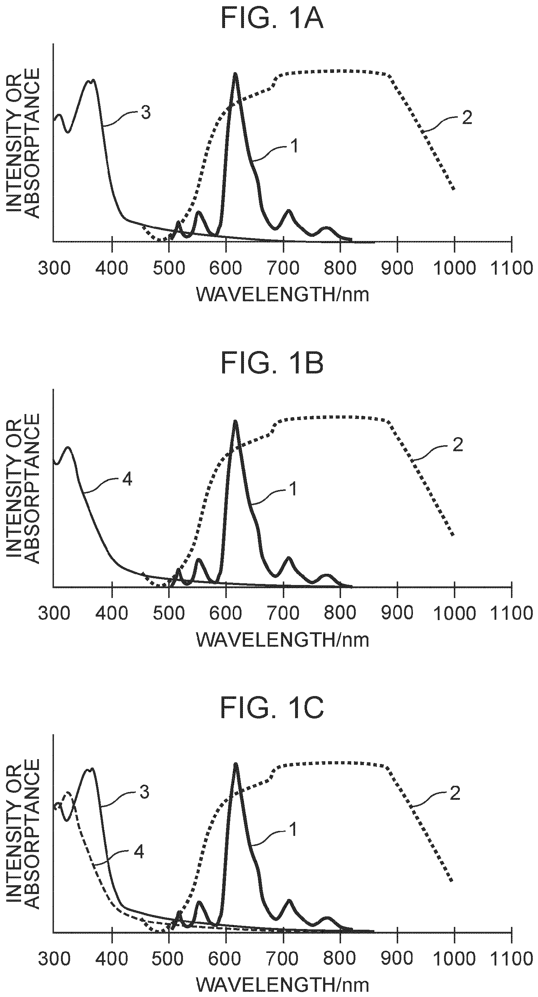

Figs. 1A to 1C are an emission spectrum and an optical absorption spectrum of an image-forming apparatus according to the present embodiment. The organic light-emitting element in the present embodiment includes a first electrode, a first organic compound layer, a light-emitting layer, a second organic compound layer, and a second electrode formed in this order on a first surface of a substrate.

In Fig. 1A, the horizontal axis represents the wavelength, and the vertical axis represents the intensity in the emission spectrum or the absorptance in the optical absorption spectrum. The emission spectrum 1 is an emission spectrum reaching the surface of the photosensitive member. The emission spectrum 1 drawn to the scale of Figs. 1A to 1C has an arbitrary unit. The optical absorption spectrum 2 of the photosensitive member is a spectrum of light absorbed by the photosensitive member. The optical absorption spectrum 3 of the first organic compound layer is a spectrum of light absorbed by an organic compound contained in the first organic compound layer. When the first organic compound layer contains a plurality of organic compounds, the optical absorption spectrum of the organic compound with the highest weight ratio among the organic compounds contained in the first organic compound layer may be taken into consideration.

The maximum emission peak wavelength in the emission spectrum 1 according to the present embodiment is closer to the wavelength at which the absorptance of the optical absorption spectrum 2 of the photosensitive member has a maximum value than the longest absorption peak wavelength in the optical absorption spectrum 2 of the first organic compound layer. Thus, in the emission spectrum 1, the amount of light absorbed by the photosensitive member is larger than the amount of light absorbed by the first organic compound layer.

In the present embodiment, the maximum emission peak wavelength in the emission spectrum is the wavelength of the peak with the highest emission intensity near 620 nm. The wavelength at which the absorptance of the optical absorption spectrum 2 of the photosensitive member has the maximum value is approximately 700 nm. When the range of the maximum value is as wide as 100 nm or more, the wavelength closest to the emission spectrum is compared. The optical absorption spectrum 3 of the first organic compound layer has the longest-wavelength peak near 380 nm. The longest-wavelength peak and the peak of the emission spectrum can be compared to estimate the amount of light absorbed by the first organic compound layer in the emission spectrum. This is because the emission spectrum and the optical absorption spectrum of the organic compound spread in the wavelength direction.

The emission spectrum and the optical absorption spectrum are determined by a material constituting the organic light-emitting element and the photosensitive member, and the material can be appropriately selected to constitute the image-forming apparatus according to the present embodiment.

The image-forming apparatus according to the present embodiment has high image formation efficiency due to the configuration in which the maximum peak wavelength in the emission spectrum is closer to the wavelength of the maximum value of the optical absorption spectrum of the photosensitive member than the longest peak wavelength in the optical absorption spectrum of the first organic compound layer.

### [Second Embodiment]

In the image-forming apparatus according to the present embodiment, the organic light-emitting element in the exposure portion includes the second organic compound layer. In Fig. 1B, as in Fig. 1A, the horizontal axis represents the wavelength, and the vertical axis represents the intensity in the emission spectrum or the absorptance in the optical absorption spectrum. The emission spectrum 1 and the optical absorption spectrum 2 of the photosensitive member are the same as those in the first embodiment. The optical absorption spectrum 4 of the second organic compound layer has the longest-wavelength peak near 350 nm. When the second organic compound layer contains a plurality of organic compounds, the organic compound with the highest weight ratio may be considered as in the case of the first organic compound layer.

The image-forming apparatus according to the present embodiment has high image formation efficiency due to the configuration in which the maximum peak wavelength in the emission spectrum is closer to the wavelength of the maximum value of the optical absorption spectrum of the photosensitive member than the longest peak wavelength in the optical absorption spectrum of the second organic compound layer.

### [Third Embodiment]

In Fig. 1C, as in Fig. 1A, the horizontal axis represents the wavelength, and the vertical axis represents the intensity in the emission spectrum or the absorptance in the optical absorption spectrum. The emission spectrum 1, the optical absorption spectrum 2 of the photosensitive member, and the absorption spectrum 3 of the first organic compound layer are the same as those in the first embodiment, and the absorption spectrum 4 of the second organic compound layer is the same as that in the second embodiment.

The image-forming apparatus according to the present embodiment has high image formation efficiency due to the configuration in which the maximum peak wavelength in the emission spectrum is closer to the wavelength of the maximum value of the optical absorption spectrum of the photosensitive member than the longest peak wavelength in the optical absorption spectrum of the first organic compound layer and the longest peak wavelength in the optical absorption spectrum of the second organic compound layer.

### [Fourth Embodiment]

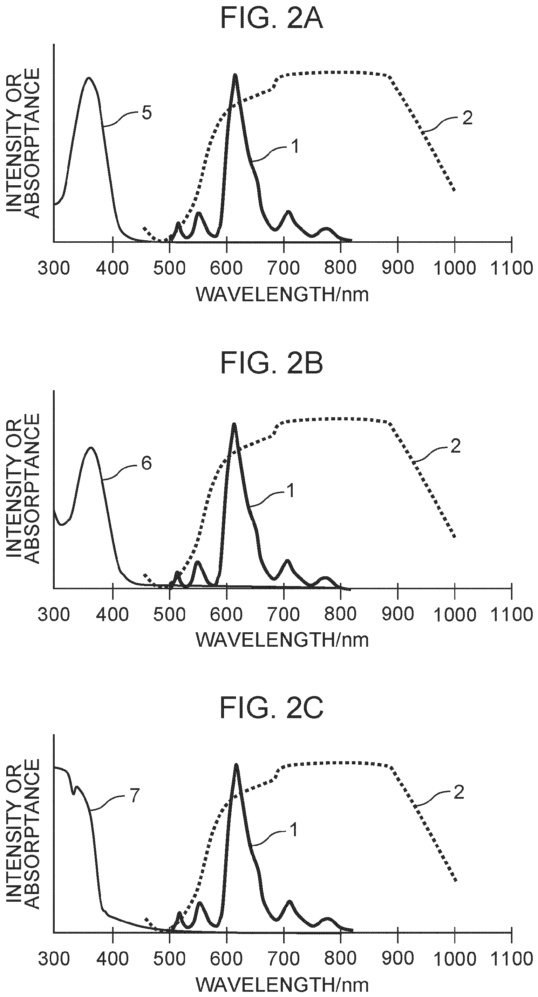

An image-forming apparatus according to the present embodiment is the same as that of the first embodiment except that the organic compound of the first organic compound layer is different. In Fig. 2A, as in Fig. 1A, the horizontal axis represents the wavelength, and the vertical axis represents the intensity in the emission spectrum or the absorptance in the optical absorption spectrum. The emission spectrum 1 and the optical absorption spectrum 2 of the photosensitive member are the same as those in the first embodiment. The optical absorption spectrum 5 of the first organic compound layer is a spectrum of light absorbed by an organic compound contained in the first organic compound layer.

The image-forming apparatus according to the present embodiment has high image formation efficiency due to the configuration in which the maximum peak wavelength in the emission spectrum is closer to the wavelength of the maximum value of the optical absorption spectrum of the photosensitive member than the longest peak wavelength in the optical absorption spectrum of the first organic compound layer.

### [Fifth Embodiment]

An image-forming apparatus according to the present embodiment is the same as that of the first embodiment except that the organic compound of the second organic compound layer is different. In Fig. 2B, as in Fig. 1A, the horizontal axis represents the wavelength, and the vertical axis represents the intensity in the emission spectrum or the absorptance in the optical absorption spectrum. The emission spectrum 1 and the optical absorption spectrum 2 of the photosensitive member are the same as those in the first embodiment. The optical absorption spectrum 6 of the second organic compound layer is a spectrum of light absorbed by an organic compound contained in the second organic compound layer.

The image-forming apparatus according to the present embodiment has high image formation efficiency due to the configuration in which the maximum peak wavelength in the emission spectrum is closer to the wavelength of the maximum value of the optical absorption spectrum of the photosensitive member than the longest peak wavelength in the optical absorption spectrum of the second organic compound layer.

### [Sixth Embodiment]

An image-forming apparatus according to the present embodiment is the same as that of the first embodiment except that the organic compound of the second organic compound layer is different. In Fig. 2C, as in Fig. 1A, the horizontal axis represents the wavelength, and the vertical axis represents the intensity in the emission spectrum or the absorptance in the optical absorption spectrum. The emission spectrum 1 and the optical absorption spectrum 2 of the photosensitive member are the same as those in the first embodiment. The optical absorption spectrum 6 of the second organic compound layer is a spectrum of light absorbed by an organic compound contained in the second organic compound layer.

The image-forming apparatus according to the present embodiment has high image formation efficiency due to the configuration in which the maximum peak wavelength in the emission spectrum is closer to the wavelength of the maximum value of the optical absorption spectrum of the photosensitive member than the longest peak wavelength in the optical absorption spectrum of the second organic compound layer.

### [Configuration of Organic Light-Emitting Element]

An organic light-emitting element is an electronic element including a first electrode, an organic compound layer, and a second electrode. Light is emitted by charge injection from these electrodes. As described above, the organic compound layer may be composed of a plurality of layers and may include, for example, a hole injection layer, a hole transport layer, a light-emitting layer, an electron transport layer, and an electron injection layer. Examples of organic compounds that can be contained in these layers are described below.

If necessary, the organic light-emitting element according to the present embodiment may be used in combination with a known low-molecular-weight or high-molecular-weight hole injection compound or hole transport compound, host compound, light-emitting compound, electron injection compound, electron transport compound, or the like. Examples of these compounds are described below.

The hole injection/transport material can be a material with high hole mobility to facilitate the injection of a hole from a positive electrode and to transport the injected hole to a light-emitting layer. Furthermore, a material with a high glass transition temperature can be used to suppress degradation of film quality, such as crystallization, in an organic light-emitting element. Examples of a low-molecular-weight or high-molecular-weight material with hole injection/transport ability include, but are not limited to, a triarylamine derivative, an aryl carbazole derivative, a phenylenediamine derivative, a stilbene derivative, a phthalocyanine derivative, a porphyrin derivative, polyvinylcarbazole, polythiophene, and another electrically conductive polymer. Furthermore, the hole injection/transport material can also be suitable for use in an electron-blocking layer. Specific examples of a compound that can be used as a hole injection/transport material include, but are not limited to, the following.

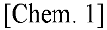

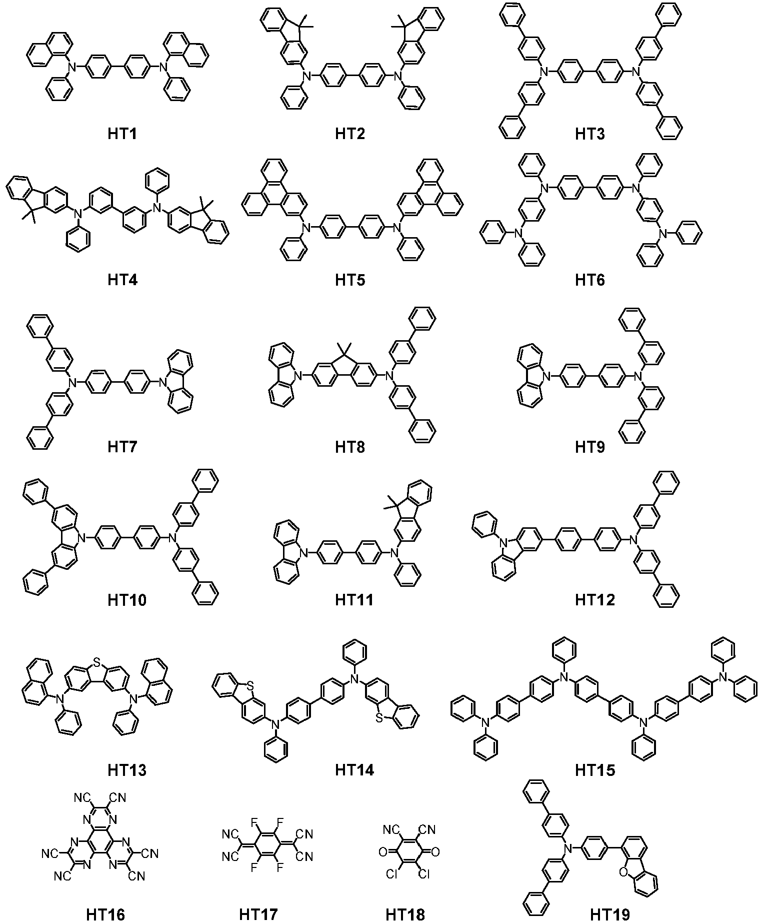

A light-emitting material mainly related to the light-emitting function may be a fused-ring compound (for example, a fluorene derivative, a naphthalene derivative, a pyrene derivative, a perylene derivative, a tetracene derivative, an anthracene derivative, rubrene, or the like), a quinacridone derivative, a coumarin derivative, a stilbene derivative, an organoaluminum complex, such as tris(8-quinolinolato)aluminum, an iridium complex, a platinum complex, a rhenium complex, a copper complex, a europium complex, a ruthenium complex, or a polymer derivative, such as a poly(phenylene vinylene) derivative, a polyfluorene derivative, or a polyphenylene derivative. Specific examples of a compound that can be used as a light-emitting material include, but are not limited to, the following.

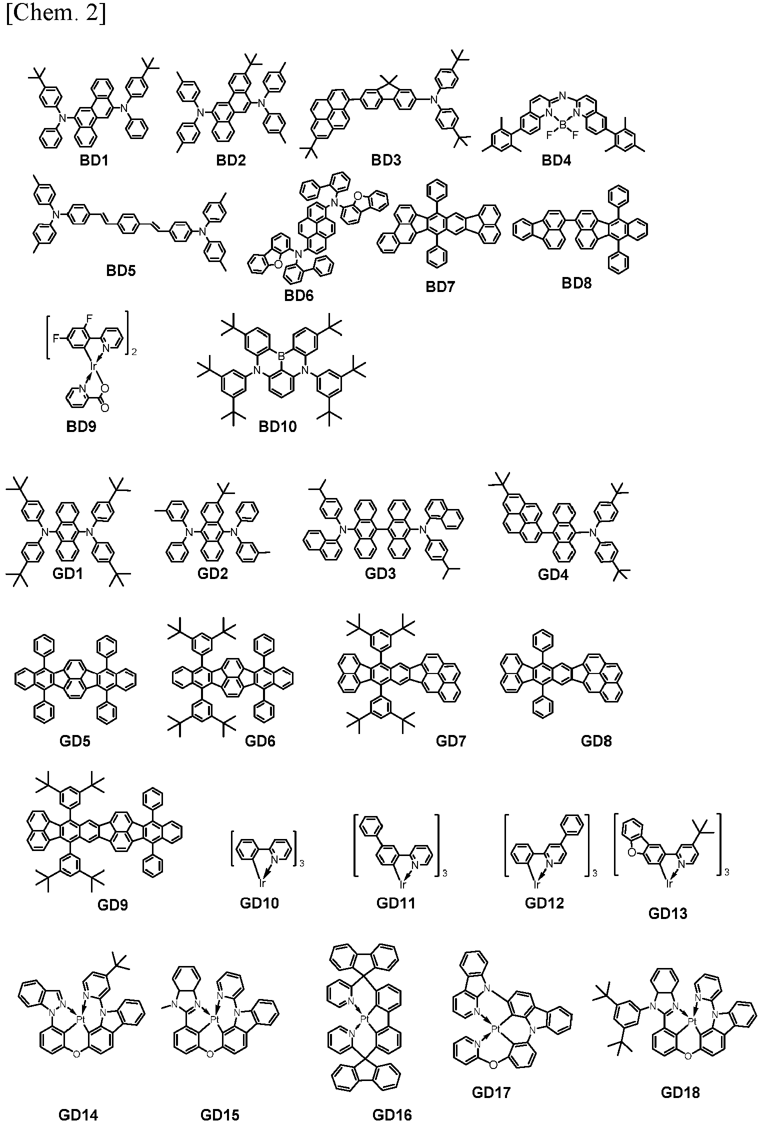

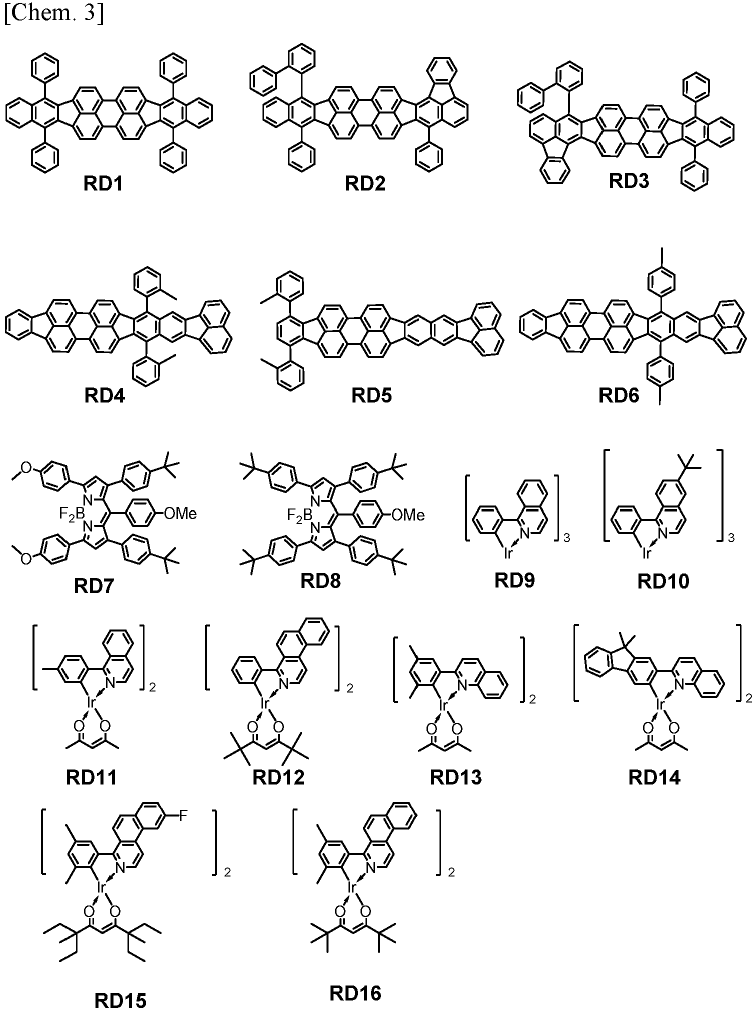

Specific examples of a host or an assist in a light-emitting layer include, but are not limited to, an aromatic hydrocarbon compound or a derivative thereof, a carbazole derivative, an azine derivative, a xanthone derivative, a dibenzofuran derivative, a dibenzothiophene derivative, an organoaluminum complex, such as tris(8-quinolinolato)aluminum, and an organoberyllium complex. Specific examples thereof are described below.

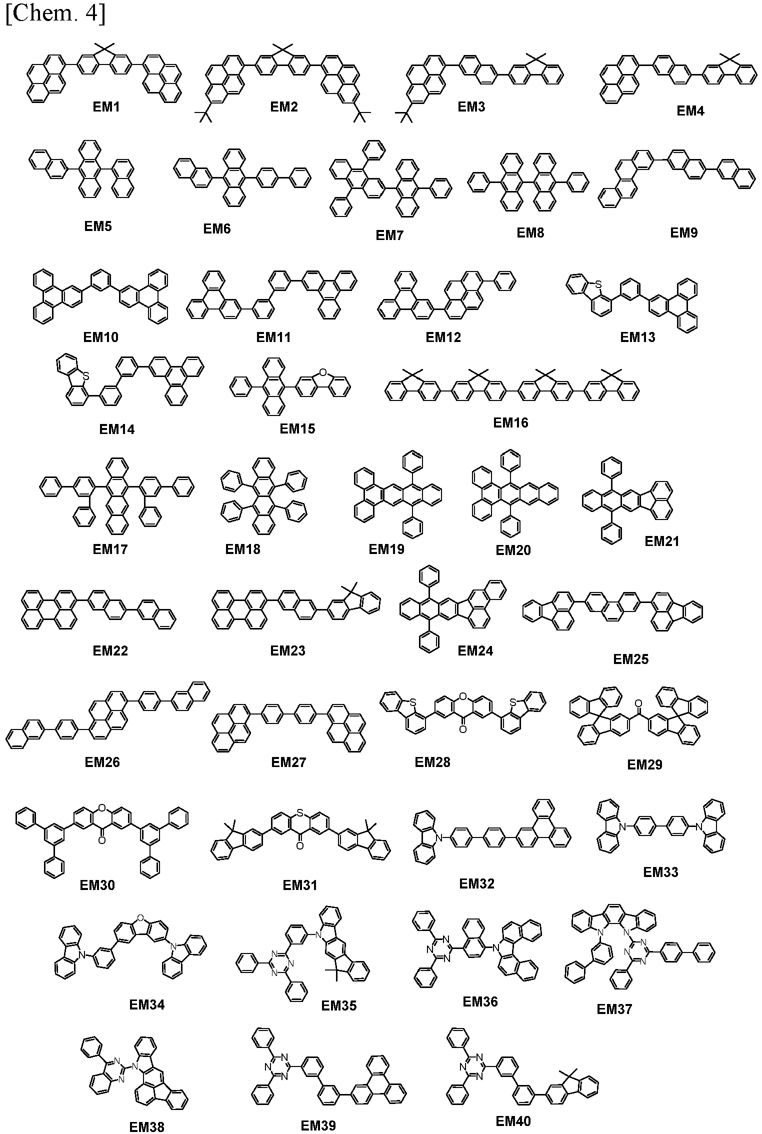

An electron transport material can be selected from materials that can transport an electron injected from the negative electrode to the light-emitting layer and is selected in consideration of the balance with the hole mobility of a hole transport material and the like. A material with electron transport ability may be an oxadiazole derivative, an oxazole derivative, a pyrazine derivative, a triazole derivative, a triazine derivative, a quinoline derivative, a quinoxaline derivative, a phenanthroline derivative, an organoaluminum complex, and a fused-ring compound (for example, a fluorene derivative, a naphthalene derivative, a chrysene derivative, an anthracene derivative, or the like). Furthermore, the electron transport material is also suitable for use in a hole-blocking layer. Specific examples of a compound that can be used as the electron transport material include, but are not limited to, the following. Specific examples thereof are described below.

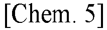

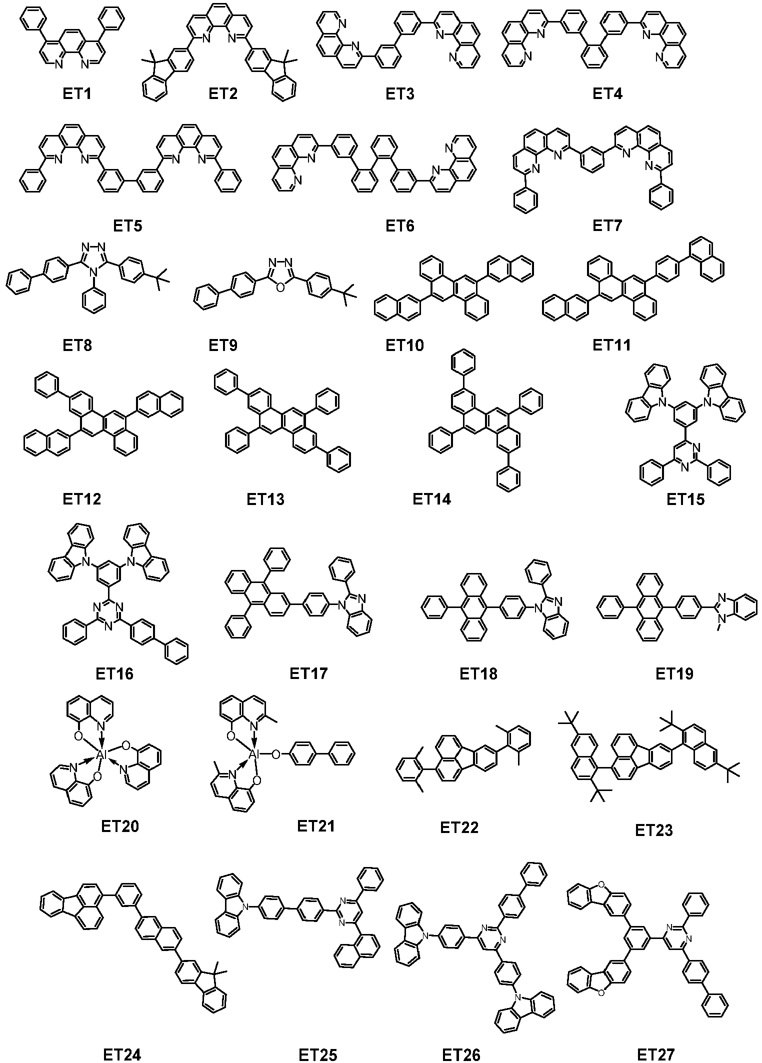

An electron injection material can be selected from materials that can easily inject an electron from the negative electrode and is selected in consideration of the balance with the hole injection properties and the like. An n-type dopant or a reducing dopant may be contained as an organic compound. Examples thereof include a compound containing an alkali metal, such as lithium fluoride, a lithium complex, such as lithium quinolinol, a benzimidazolidene derivative, an imidazolidene derivative, a fulvalene derivative, and an acridine derivative. It can also be used in combination with the electron transport material.

### <Other Configurations of Organic Light-Emitting Element>

An organic light-emitting element includes an insulating layer, a first electrode, an organic compound layer, and a second electrode on a first surface of a substrate. A protective layer, a color filter, a microlens, or the like may be provided on the second electrode. When a color filter is provided, a planarization layer may be provided between the color filter and the protective layer. The planarization layer may be composed of an acrylic resin or the like. The same applies to the planarization layer provided between the color filter and the microlens.

### [Substrate]

The substrate may be formed of quartz, glass, a silicon wafer, resin, metal, or the like. The substrate may have a switching element, such as a transistor, and wiring, on which an insulating layer may be provided. The insulating layer may be composed of any material, provided that the insulating layer can have a contact hole for wiring between the insulating layer and the first electrode and is insulated from unconnected wires. For example, the insulating layer may be formed of a resin, such as polyimide, silicon oxide, or silicon nitride.

### [Electrode]

A pair of electrodes can be used as electrodes. The pair of electrodes may be a positive electrode and a negative electrode. When an electric field is applied in a direction in which the organic light-emitting element emits light, an electrode with a high electric potential is a positive electrode, and the other electrode is a negative electrode. In other words, the electrode that supplies a hole to the light-emitting layer is a positive electrode, and the electrode that supplies an electron to the light-emitting layer is a negative electrode.

A constituent material of the positive electrode can have as large a work function as possible. Examples thereof include a metal element, such as gold, platinum, silver, copper, nickel, palladium, cobalt, selenium, vanadium, or tungsten, a mixture thereof, an alloy thereof, and a metal oxide, such as tin oxide, zinc oxide, indium oxide, indium tin oxide (ITO), or indium zinc oxide. An electrically conductive polymer, such as polyaniline, polypyrrole, or polythiophene, may also be used.

These electrode materials may be used alone or in combination. The positive electrode may be composed of a single layer or a plurality of layers.

When used as a reflective electrode, for example, chromium, aluminum, silver, titanium, tungsten, molybdenum, an alloy thereof, or a laminate thereof can be used. These materials can also function as a reflective film that does not have a role as an electrode. When used as a transparent electrode, an oxide transparent electroconductive layer, such as indium tin oxide (ITO) or indium zinc oxide, can be used. However, the present disclosure is not limited thereto. The electrodes may be formed by photolithography.

On the other hand, a constituent material of the negative electrode can be a material with a small work function. For example, an alkali metal, such as lithium, an alkaline-earth metal, such as calcium, a metal element, such as aluminum, titanium, manganese, silver, lead, or chromium, or a mixture thereof may be used. An alloy of these metal elements may also be used. For example, magnesium-silver, aluminum-lithium, aluminum-magnesium, silver-copper, or zinc-silver may be used. A metal oxide, such as indium tin oxide (ITO), may also be used. These electrode materials may be used alone or in combination. The negative electrode may be composed of a single layer or a plurality of layers. In particular, silver can be used, and a silver alloy can be used to reduce the aggregation of silver. As long as the aggregation of silver can be reduced, the alloy may have any ratio. For example, the ratio of silver to another metal may be 1:1, 3: 1, or the like.

The negative electrode may be, but is not limited to, an oxide electroconductive layer, such as ITO, for a top emission element or a reflective electrode, such as aluminum (Al), for a bottom emission element. The negative electrode may be formed by any method. A direct-current or alternating-current sputtering method can achieve good film coverage and easily decrease resistance.

### [Organic Compound Layer]

An organic compound layer constituting an organic light-emitting element according to an embodiment of the present disclosure can be formed by a dry process, such as a vacuum evaporation method, an ionized deposition method, sputtering, or plasma. Instead of the dry process, a wet process may also be employed in which a layer is formed by a known coating method (for example, spin coating, dipping, a casting method, an LB method, an ink jet method, or the like) using an appropriate solvent.

A layer formed by a vacuum evaporation method, a solution coating method, or the like undergoes little crystallization or the like and has high temporal stability. When a film is formed by a coating method, the film may also be formed in combination with an appropriate binder resin.

The binder resin may be, but is not limited to, a polyvinylcarbazole resin, a polycarbonate resin, a polyester resin, an ABS resin, an acrylic resin, a polyimide resin, a phenolic resin, an epoxy resin, a silicone resin, or a urea resin.

These binder resins may be used alone or in combination as a homopolymer or a copolymer. If necessary, an additive agent, such as a known plasticizer, oxidation inhibitor, and/or ultraviolet absorbent, may also be used.

### [Charge Generation Layer]

As a charge generation layer, an n/p junction is formed by a p-layer and an n-layer, or a p-doped layer or an n-doped layer is used. For example, in the case of forming only a P/N junction, an electron injection layer can be provided to further inject an electron extracted by a p-layer into an electron transport layer. An n-doped layer/p-doped layer may be used. The present disclosure is not limited to any combination as the charge generation layer.

In the p-doped layer, for example, a Lewis acid, such as HAT-CN or molybdenum oxide, with high electron-withdrawing ability and an aromatic amine compound may be mixed. HAT-CN, molybdenum trioxide, or the like is an n-type material and may have a layered configuration by extracting an electron. A p-doped layer or an np junction formed by stacking an n-type material and a p-type material is treated as a p-charge generation layer.

For example, the n-doped layer can be composed of a material with a low work function, such as an alkali metal or an alkaline-earth metal, which can be easily doped with an electron. The n-doped layer is treated as an n-charge generation layer in the present disclosure. Alternatively, LiF or the like may be combined with a reducing metal thin film to form an electron injection layer, forming an n-type layer/p-type layer for charge generation.

An n-dopant can be an alkali metal, such as Li, Na, K, Rb, or Cs, an alkaline-earth metal, such as Mg, Ca, Sr, or Ba, a rare-earth metal, such as Yb, a compound thereof (including an alkali metal compound (including an oxide, such as lithium oxide, a halide, or a carbonate, such as lithium carbonate or cesium carbonate), an alkaline-earth metal compound (including an oxide, a halide, or a carbonate), a compound of a rare-earth metal (including an oxide, a halide, or a carbonate), or the like.

### [Protective Layer]

A protective layer may be provided on the second electrode. For example, a glass sheet with a moisture absorbent may be attached to the second electrode to decrease the amount of water or the like entering the organic compound layer and to reduce the occurrence of display defects. In another embodiment, a passivation film of silicon nitride or the like may be provided on the second electrode to decrease the amount of water or the like entering the organic compound layer. For example, the second electrode may be formed and then transferred to another chamber without breaking the vacuum, and a silicon nitride film with a thickness of 2 µm may be formed as a protective layer by a chemical vapor deposition (CVD) method. The film formation by the CVD method may be followed by the formation of a protective layer by an atomic layer deposition (ALD) method. A film formed by the ALD method may be formed of any material, such as silicon nitride, silicon oxide, or aluminum oxide. Silicon nitride may be further formed by the CVD method on the film formed by the ALD method. The film formed by the ALD method may have a smaller thickness than the film formed by the CVD method. More specifically, the thickness may be 50% or less or even 10% or less.

### [Planarization Layer]

A planarization layer may be provided on the protective layer. The planarization layer is provided to reduce the roughness of the underlayer. The planarization layer is sometimes referred to as a material resin layer with any purpose. The planarization layer may be composed of an organic compound and can be composed of a high-molecular-weight compound, though it may be composed of a low-molecular-weight compound.

The planarization layer may be provided above and below a color filter, and the constituent materials thereof may be the same or different. Specific examples include a polyvinylcarbazole resin, a polycarbonate resin, a polyester resin, an ABS resin, an acrylic resin, a polyimide resin, a phenolic resin, an epoxy resin, a silicone resin, and a urea resin.

### [Microlens]

An organic light-emitting element or a light-emitting apparatus with an organic light-emitting element may include an optical member, such as a microlens, on the light output side. The microlens may be composed of an acrylic resin, an epoxy resin, or the like. The microlens may be used to increase the amount of light extracted from an organic light-emitting element or light-emitting apparatus and control the direction of the extracted light. The microlens may have a hemispherical shape. For a hemispherical microlens, the vertex of the microlens is a contact point between the hemisphere and a tangent line parallel to the insulating layer among the tangent lines in contact with the hemisphere. The vertex of the microlens in any cross-sectional view can be determined in the same manner. More specifically, the vertex of the microlens in a cross-sectional view is a contact point between the semicircle of the microlens and a tangent line parallel to the insulating layer among the tangent lines in contact with the semicircle.

The midpoint of the microlens can also be defined. In a cross section of the microlens, a midpoint of a line segment from one end point to the other end point of the arc can be referred to as a midpoint of the microlens. A cross section in which the vertex and the midpoint are determined may be perpendicular to the insulating layer.

### [Opposite Substrate]

An opposite substrate may be provided on the planarization layer. The opposite substrate is so called because it faces the substrate. The opposite substrate may be composed of the same material as the substrate. When the substrate is a first substrate, the opposite substrate may be a second substrate.

### [Pixel Circuit]

A light-emitting apparatus including an organic light-emitting element may include a pixel circuit coupled to the organic light-emitting element. The pixel circuit may be of an active matrix type, which independently controls the light emission of a plurality of organic light-emitting elements. The active-matrix circuit may be voltage programmed or current programmed. The drive circuit has a pixel circuit for each pixel. The pixel circuit may include an organic light-emitting element, a transistor for controlling the luminous brightness of the organic light-emitting element, a transistor for controlling light emission timing, a capacitor for holding the gate voltage of the transistor for controlling the luminous brightness, and a transistor for GND connection without through the light-emitting element.

A light-emitting apparatus includes a display region and a peripheral region around the display region. The display region includes the pixel circuit, and the peripheral region includes a display control circuit. The mobility of a transistor constituting the pixel circuit may be smaller than the mobility of a transistor constituting the display control circuit. The gradient of the current-voltage characteristics of a transistor constituting the pixel circuit may be smaller than the gradient of the current-voltage characteristics of a transistor constituting the display control circuit. The gradient of the current-voltage characteristics can be determined by so-called Vg-Ig characteristics. A transistor constituting the pixel circuit is a transistor coupled to an organic light-emitting element.

The drive circuit may control the luminous point of an exposure portion and may include a transistor that controls the amount of electric current flowing through the organic light-emitting element and the timing of light emission.

### [Configuration of Image-Forming Apparatus]

An image-forming apparatus according to the present disclosure includes a photosensitive member and an exposure portion, and the exposure portion includes the organic light-emitting element. The photosensitive member and a photosensitive drum are described below.

### [Photosensitive Member]

The photosensitive member includes an underlying layer, a charge generation layer, a charge transport layer, and a surface layer on a supporting member. A photosensitive layer may be a multilayer photosensitive layer including a charge generation layer and a charge transport layer or may be a monolayer photosensitive layer containing a charge generation material and a charge transport material.

A method for producing a photosensitive drum according to the present disclosure may be a method of preparing a coating liquid for each layer described later, applying a desired layer in order, and drying the layer. A method for applying the coating liquid may be dip coating, spray coating, ink jet coating, roll coating, die coating, blade coating, curtain coating, wire bar coating, ring coating, or the like. Among these, dip coating is efficient and productive.

The configuration of a photosensitive drum according to the present disclosure is described below.

### [Supporting Member]

The photosensitive drum can have an electrically conductive supporting member (electroconductive supporting member). The supporting member in the present disclosure has a drum shape (cylindrical shape). A surface of the supporting member may be subjected to electrochemical treatment, such as anodic oxidation, abrasive blasting, cutting, or the like.

A material of the supporting member can be a metal, a resin, glass, or the like. The metal may be aluminum, iron, nickel, copper, gold, stainless steel, an alloy thereof, or the like. In particular, an aluminum supporting member containing aluminum can be used.

A treatment, such as mixing or coating with a conductive material, can impart electrical conductivity to the resin or glass.

### [Underlying Layer]

In the present disclosure, an underlying layer may be provided on the supporting member. The underlying layer is provided for the purpose of improving the adhesiveness of the photosensitive layer, improving the coatability, improving the charge injection properties from the supporting member, protecting the photosensitive layer from electrical breakdown, suppressing interference fringes due to scattering of image exposure, and the like. As the underlying layer, one underlying layer containing each of the materials described below may be provided, or two or more different underlying layers containing each of the materials described below may be stacked.

Particles of indium tin oxide, tin oxide, indium oxide, titanium oxide, strontium titanate, zinc oxide, aluminum oxide, or the like are used as metal oxide particles. Silicon dioxide particles can also be used. Particles of gold, silver, aluminum, or the like can be used as metal particles.

Primary particles of the metal oxide particles preferably have a number-average particle size of 0.1 µm or less from the perspective of the dispersibility of a coating liquid for an underlying layer and the electrical characteristics of the photosensitive drum.

In the present disclosure, the metal oxide particles may be a mixture of two or more types of metal oxide particles of different metal oxides, metal oxide particles subjected to different surface treatments, metal oxide particles with different particle sizes or specific surface areas, or the like.

The surface of the metal oxide particles in the underlying layer may be treated with a surface treatment agent, such as a silane coupling agent, to suppress a black-dot-like image defect due to charge injection from the supporting member to the photosensitive layer side.

The metal oxide particles may be surface-treated by a general method. For example, a dry method or a wet method may be mentioned.

In the dry method, while the metal oxide particles are stirred in a mixer capable of high-speed stirring, such as a Henschel mixer, an aqueous alcohol, an organic solvent solution, or an aqueous solution containing a surface treatment agent is added, uniformly dispersed, and then dried.

In the wet method, the metal oxide particles and a surface treatment agent in a solvent are stirred or dispersed with glass beads or the like in a sand mill or the like. The dispersion is followed by filtration or vacuum distillation to remove the solvent. After the solvent is removed, baking can be performed at 100°C or more.

The underlying layer can contain a resin. Furthermore, a composition containing a monomer with a polymerizable functional group may be polymerized to form the underlying layer as a cured film.

The resin is, for example, an acrylic resin, an allyl resin, an alkyd resin, an ethyl cellulose resin, an ethylene-acrylic acid copolymer, an epoxy resin, a casein resin, or a silicone resin. A gelatin resin, a phenolic resin, a urethane resin, a butyral resin, a polyacrylate resin, a polyacetal resin, a polyamide-imide resin, a polyamide resin, a polyallyl ether, a polyimide resin, a polyester resin, or a polyethylene resin may also be mentioned. A polycarbonate resin, a polystyrene resin, a polysulfone resin, a polyvinyl alcohol resin, a polybutadiene resin, or a polypropylene resin may also be mentioned. In particular, a urethane resin with low hygroscopicity can be used to suppress voltage fluctuations in a high-temperature and high-humidity environment.

The polymerizable functional group may be an isocyanate group, a blocked isocyanate group, a methylol group, an alkylated methylol group, an epoxy group, a metal alkoxide group, a hydroxy group, an amino group, a carboxy group, a thiol group, a carboxylic anhydride group, a carbon-carbon double bond group, or the like.

The mass ratio (P/B) of the metal oxide particles (P) to the binder resin (B) in the underlying layer is preferably 1.0/1.0 or more and 3.0/1.0 or less.

The underlying layer may further contain an electron transport material, metal particles, an electrically conductive polymer, or the like to enhance electrical characteristics. In particular, an electron transport material can be used.

The electron transport material may be a quinone compound, an imide compound, a benzimidazole compound, a cyclopentadienylidene compound, a fluorenone compound, an oxadiazole compound, a diphenoquinone compound, a xanthone compound, an alizarin compound, a benzophenone compound, a cyanovinyl compound, a halogenated aryl compound, a silole compound, a boron-containing compound, or the like.

The underlying layer may be formed as a cured film by using an electron transport material with a polymerizable functional group as the electron transport material and copolymerizing the electron transport material and the monomer with a polymerizable functional group.

The underlying layer may further contain organic resin particles or a leveling agent for the purpose of, for example, adjusting the surface roughness, promoting light scattering, or reducing cracks. The organic resin particles may be, but are not limited to, hydrophobic organic resin particles, such as silicone particles, or hydrophilic organic resin particles, such as cross-linked polymethacrylate resin (PMMA) particles.

The underlying layer may further contain an additive agent, for example, a known material, such as electrically conductive material particles, such as carbon black, a charge transport material, a metal chelate compound, or an organometallic compound.

The underlying layer can be formed by preparing a coating liquid for the underlying layer containing the materials described above and a solvent, forming a coating film of the coating liquid on the supporting member or the electroconductive layer, and drying and/or curing the coating film.

The solvent for use in the coating liquid for the underlying layer may be an organic solvent, such as an alcohol, a sulfoxide, a ketone, an ether, an ester, an aliphatic halogenated hydrocarbon, or an aromatic compound. An alcohol or ketone solvent can be used in the present disclosure.

The coating liquid for the underlying layer may be prepared by a dispersion method using a homogenizer, an ultrasonic homogenizer, a ball mill, a sand mill, a rolling mill, a vibrating mill, an attritor, or a liquid-collision-type high-speed dispersing apparatus.

The underlying layer preferably has a thickness of 0.1 µm or more, more preferably 0.2 µm or more, particularly preferably 0.3 µm or more. The underlying layer preferably has a thickness of 50 µm or less, more preferably 40 µm or less, still more preferably 30 µm or less.

### [Photosensitive Layer]

The photosensitive layer of the photosensitive drum is mainly classified into (1) a multilayer photosensitive layer and (2) a monolayer photosensitive layer. (1) The multilayer photosensitive layer is a photosensitive layer including a charge generation layer containing a charge generation material and a charge transport layer containing a charge transport material. (2) The monolayer photosensitive layer is a photosensitive layer containing both a charge generation material and a charge transport material.

### (1) Multilayer Photosensitive Layer

The multilayer photosensitive layer includes the charge generation layer and the charge transport layer.

### (1-1) Charge Generation Layer

The charge generation layer can contain the charge generation material and a resin.

The charge generation material may be an azo pigment, a perylene pigment, a polycyclic quinone pigment, an indigo pigment, a phthalocyanine pigment, or the like. In particular, an azo pigment and a phthalocyanine pigment can be used. The phthalocyanine pigment can be an oxytitanium phthalocyanine pigment, a chlorogallium phthalocyanine pigment, or a hydroxygallium phthalocyanine pigment.

The charge generation material content of the charge generation layer is preferably 40% by mass or more and 85% by mass or less, more preferably 60% by mass or more and 80% by mass or less, of the total mass of the charge generation layer.

The resin may be a polyester resin, a polycarbonate resin, a poly(vinyl acetal) resin, a poly(vinyl butyral) resin, an acrylic resin, a silicone resin, an epoxy resin, a melamine resin, a polyurethane resin, a phenolic resin, a poly(vinyl alcohol) resin, a cellulose resin, a polystyrene resin, a poly(vinyl acetate) resin, a poly(vinyl chloride) resin, or the like. In particular, a poly(vinyl butyral) resin can be used.

The charge generation layer may further contain an additive agent, such as an oxidation inhibitor or an ultraviolet absorbent. Specific examples thereof include a hindered phenol compound, a hindered amine compound, a sulfur compound, a phosphorus compound, and a benzophenone compound.

The charge generation layer can be formed by preparing a coating liquid for a charge generation layer containing the materials described above and a solvent, forming a coating film of the coating liquid on the underlying layer, and drying the coating film. The solvent in the coating liquid may be an alcohol solvent, a sulfoxide solvent, a ketone solvent, an ether solvent, an ester solvent, an aromatic hydrocarbon solvent, or the like.

The charge generation layer has a thickness of 0.1 µm or more and 1 µm or less, more preferably 0.15 µm or more and 0.4 µm or less.

### (1-2) Charge Transport Layer

The charge transport layer can contain the charge transport material and a binder material.

When a protective layer described later is not provided, the charge transport layer serves as a surface layer of the photosensitive drum.

The charge transport material is, for example, a polycyclic aromatic compound, a heterocyclic compound, a hydrazone compound, a styryl compound, an enamine compound, a triarylamine compound, a resin with a group derived from these materials, or the like. In particular, a triarylamine compound can be used.

The charge transport material content of the charge transport layer is preferably 25% by mass or more and 70% by mass or less, more preferably 30% by mass or more and 55% by mass or less, of the total mass of the charge transport layer.

The binder material is a thermoplastic resin (hereinafter also referred to as a "resin").

The thermoplastic resin may be a polyester resin, a polycarbonate resin, an acrylic resin, a polystyrene resin, or the like. In particular, a polycarbonate resin and a polyester resin can be used. The polyester resin can be a polyarylate resin.

The ratio (mass ratio) of the charge transport material content to the resin content preferably ranges from 4:10 to 20:10, more preferably 5:10 to 12:10.

The charge transport layer may contain an additive agent, such as an oxidation inhibitor, an ultraviolet absorbent, a plasticizer, or a leveling agent. Specific examples thereof include a hindered phenol compound, a hindered amine compound, a sulfur compound, a phosphorus compound, a benzophenone compound, a siloxane-modified resin, a silicone oil, polystyrene resin particles, polyethylene resin particles, and boron nitride particles.

The charge transport layer can be formed by preparing a coating liquid for a charge transport layer containing the materials described above and a solvent, forming a coating film of the coating liquid on the charge generation layer, and drying the coating film. The solvent in the coating liquid may be an alcohol solvent, a ketone solvent, an ether solvent, an ester solvent, or an aromatic hydrocarbon solvent. In particular, an ether solvent or an aromatic hydrocarbon solvent can be used.

The charge transport layer preferably has a thickness of 5 µm or more and 50 µm or less, more preferably 8 µm or more and 40 µm or less, particularly preferably 10 µm or more and 30 µm or less.

### (2) Monolayer Photosensitive Layer

The monolayer photosensitive layer can be formed by preparing a photosensitive layer coating liquid containing a charge generation material, a charge transport material, a resin, and a solvent, forming a coating film of the coating liquid on the underlying layer, and drying the coating film. The charge generation material, the charge transport material, and the resin are the same as the examples of the materials in "(1) Multilayer Photosensitive Layer" described above.

### [Protective Layer]

In the present disclosure, a protective layer may be provided on the photosensitive layer. The protective layer can improve durability. When the protective layer is provided, the protective layer serves as a surface layer of the photosensitive drum. The protective layer may be formed as a cured film by polymerizing a composition containing, for example, a monomer with a polymerizable functional group, which is a raw material of the binder material. A reaction at that time may be a thermal polymerization reaction, a photopolymerization reaction, a radiation-induced polymerization reaction, or the like. The polymerizable functional group in the monomer with the polymerizable functional group is, for example, an isocyanate group, a blocked isocyanate group, a methylol group, an alkyl methylol group, an epoxy group, a metal alkoxy group, a hydroxy group, an amino group, a carboxy group, a thiol group, a carboxylic anhydride group, a group with a carbon-carbon double bond, or the like. The group with a carbon-carbon double bond is, for example, an acryloyl group, a methacryloyl group, or the like. The monomer with a polymerizable functional group may be a monomer with charge transport ability.

A cured product of the monomer with a polymerizable functional group is the binder material of the protective layer. The monomer with a polymerizable functional group can be a hole transport compound with a chain-polymerizable functional group.

The hole transport compound with a chain-polymerizable functional group can be a compound represented by the following formula (CT-1) or (CT-2).

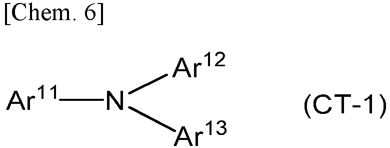

In the formula (CT-1), Ar11 to Ar13 each independently denote a substituted aryl group or an unsubstituted aryl group. A substituent that the substituted aryl group may have is an alkyl group with 1 or more and 6 or less carbon atoms or a monovalent functional group represented by any one of the following formulae (P-1) to (P-3). The compound represented by the formula (CT-1) has at least one monovalent functional group represented by any one of the following formulae (P-1) to (P-3).

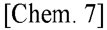

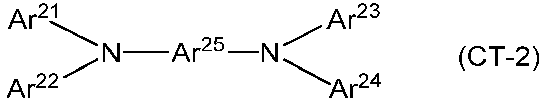

In the formula (CT-2), Ar21 to Ar24 each independently denote a substituted aryl group or an unsubstituted aryl group, and Ar25 denotes a substituted arylene group or an unsubstituted arylene group. A substituent that the substituted aryl group may have is an alkyl group with 1 or more and 6 or less carbon atoms or a monovalent functional group represented by any one of the following formulae (P-1) to (P-3). A substituent that the substituted arylene group may have is an alkyl group with 1 or more and 6 or less carbon atoms or a monovalent functional group represented by any one of the following formulae (P-1) to (P-3). The compound represented by the formula (CT-2) has at least one monovalent functional group represented by any one of the following formulae (P-1) to (P-3).

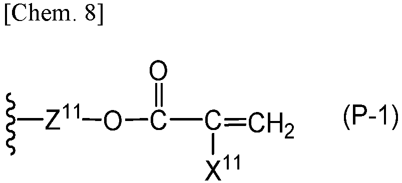

In the formula (P-1), Z11 denotes a single bond or an alkylene group with 1 or more and 6 or less carbon atoms, and X11 denotes a hydrogen atom or a methyl group.

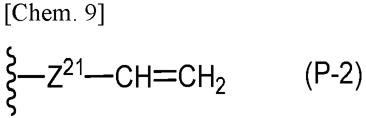

In the formula (P-2), Z21 denotes a single bond or an alkylene group with 1 or more and 6 or less carbon atoms.

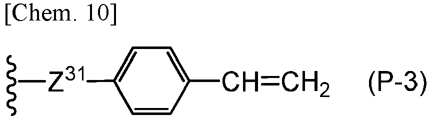

In the formula (P-3), Z31 denotes a single bond or an alkylene group with 1 or more and 6 or less carbon atoms.

The protective layer may contain resin particles containing a fluorine atom. The resin particles containing a fluorine atom can improve the wear resistance of the protective layer.

The resin in the resin particles containing a fluorine atom is, for example, as follows: a polytetrafluoroethylene resin, a polychlorotrifluoroethylene resin, a polytetrafluoroethylene propylene resin, a poly(vinyl fluoride) resin, a poly(vinylidene difluoride) resin, or polydichlorodifluoroethylene resin. Particles containing a plurality types of the resins can also be used. In particular, the resin particles containing a fluorine atom can be a polytetrafluoroethylene (PTFE) resin to improve dispersibility.

In the cross-sectional observation of the surface layer, the arithmetic mean of the long diameters of the primary particles (average primary particle size) of the resin particles containing a fluorine atom measured from a secondary electron image using a scanning electron microscope is preferably 150 nm or more and 300 nm or less from the perspective of improving dispersibility and suppressing voltage fluctuations. More preferably, the resin particles containing a fluorine atom have an average primary particle size of 180 nm or more and 250 nm or less.

The amount of the resin particles containing a fluorine atom in the protective layer is preferably 5% by mass or more and 40% by mass or less, more preferably 25% by mass or more and 35% by mass or less, of the total mass of the protective layer.

The protective layer may contain an additive agent, such as an oxidation inhibitor, an ultraviolet absorbent, a plasticizer, or a leveling agent. Specific examples thereof include a hindered phenol compound, a hindered amine compound, a sulfur compound, a phosphorus compound, a benzophenone compound, a siloxane-modified resin, a silicone oil, polystyrene resin particles, polyethylene resin particles, and boron nitride particles.

The protective layer can be formed by preparing a coating liquid for a protective layer containing the materials described above and a solvent, forming a coating film of the coating liquid on the photosensitive layer, and drying and/or curing the coating film. The solvent in the coating liquid may be an alcohol solvent, a ketone solvent, an ether solvent, a sulfoxide solvent, an ester solvent, or an aromatic hydrocarbon solvent.

The protective layer preferably has a thickness of 0.50 µm or more and 10 µm or less, more preferably 1 µm or more and 7 µm or less.

### [Surface Processing of Photosensitive Drum]

In the present disclosure, the photosensitive drum may be subjected to surface processing. The surface processing can further stabilize the behavior of a cleaning member (cleaning blade) brought into contact with the photosensitive drum. The surface processing method may be a method of bringing a mold with a protrusion into pressure contact with the surface of the photosensitive drum to transfer the shape, a method of imparting a concavo-convex shape by mechanical polishing, or a method of colliding a powder with the surface of the photosensitive drum to roughen the surface. The recess or protrusion thus formed on the surface layer of the photosensitive drum can further stabilize the behavior of the cleaning member coming into contact with the photosensitive drum.

The recess or protrusion may be formed on the entire surface of the photosensitive drum or may be formed on a portion of the surface of the photosensitive drum. When the recess or protrusion is formed on a portion of the surface of the photosensitive drum, the recess or protrusion can be formed at least on the entire contact region with the cleaning member (cleaning blade).

To form the recess, a mold with a protrusion corresponding to the recess can be brought into pressure contact with the surface of the photosensitive drum to transfer the shape and form the recess on the surface of the photosensitive drum.

### [Configuration Example of Organic Light-Emitting Element and Image-Forming Apparatus]

Configuration examples of the organic light-emitting element and the image-forming apparatus are described below.

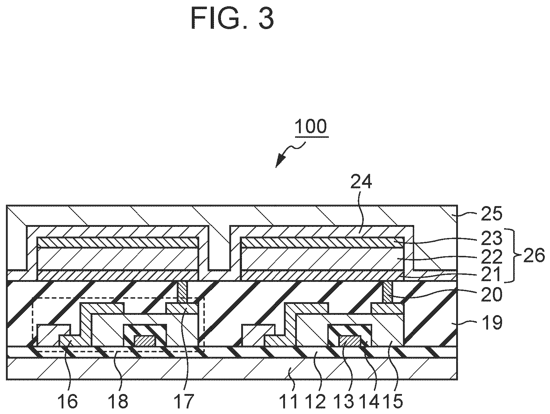

A display apparatus 100 in Fig. 3 includes an organic light-emitting element 26 and a TFT 18 as an example of a transistor. The display apparatus 100 includes a substrate 11 made of glass, silicon, or the like and an insulating layer 12 on the substrate 11. The display apparatus 100 includes, on the insulating layer, an active element 18, such as a TFT, and a gate electrode 13, a gate-insulating film 14, and a semiconductor layer 15 of the active element. The TFT 18 is also composed of the semiconductor layer 15, a drain electrode 16, and a source electrode 17. The TFT 18 is covered with an insulating film 19. A positive electrode 21 of the organic light-emitting element 26 is coupled to the source electrode 17 through a contact hole 20 formed in the insulating film.

The method for electrically connecting the electrodes (the positive electrode and a negative electrode) of the organic light-emitting element 26 to the electrodes (the source electrode and the drain electrode) of the TFT is not limited to the embodiment illustrated in Fig. 3. More specifically, it is only necessary to electrically connect one of the positive electrode and the negative electrode to one of the source electrode and the drain electrode of the TFT. TFT refers to a thin-film transistor.

An organic compound layer 22 in the display apparatus 100 in Fig. 3 is a single layer but may be composed of a plurality of layers. The negative electrode 23 is covered with a first protective layer 24 and a second protective layer 25 for reducing degradation of the organic light-emitting element.

The display apparatus 100 in Fig. 3 includes a transistor as a switching element but may include another switching element instead thereof.

The transistor used in the display apparatus 100 in Fig. 3 is not limited to a transistor including a single crystal silicon wafer and may also be a thin-film transistor including an active layer on an insulating surface of a substrate. The active layer may be single-crystal silicon, non-single-crystal silicon, such as amorphous silicon or microcrystalline silicon, or a non-single-crystal oxide semiconductor, such as indium zinc oxide or indium gallium zinc oxide. The thin-film transistor is also referred to as a TFT element.

The transistor in the display apparatus 100 in Fig. 3 may be formed within a substrate, such as a Si substrate. The phrase "formed within a substrate" means that the substrate, such as a Si substrate, itself is processed to form the transistor. Thus, the transistor within the substrate can be considered that the substrate and the transistor are integrally formed.

In the organic light-emitting element according to the present embodiment, the luminous brightness is controlled with the TFT, which is an example of a switching element. The organic light-emitting element can be provided in a plurality of planes to display an image at each luminous brightness. The switching element according to the present embodiment is not limited to the TFT and may be a transistor formed of low-temperature polysilicon or an active-matrix driver formed on a substrate, such as a Si substrate. The phrase "on a substrate" may also be referred to as "within a substrate". Whether a transistor is provided within a substrate or a TFT is used depends on the size of a display unit. For example, for an approximately 0.5-inch display unit, an organic light-emitting element can be provided on a Si substrate.

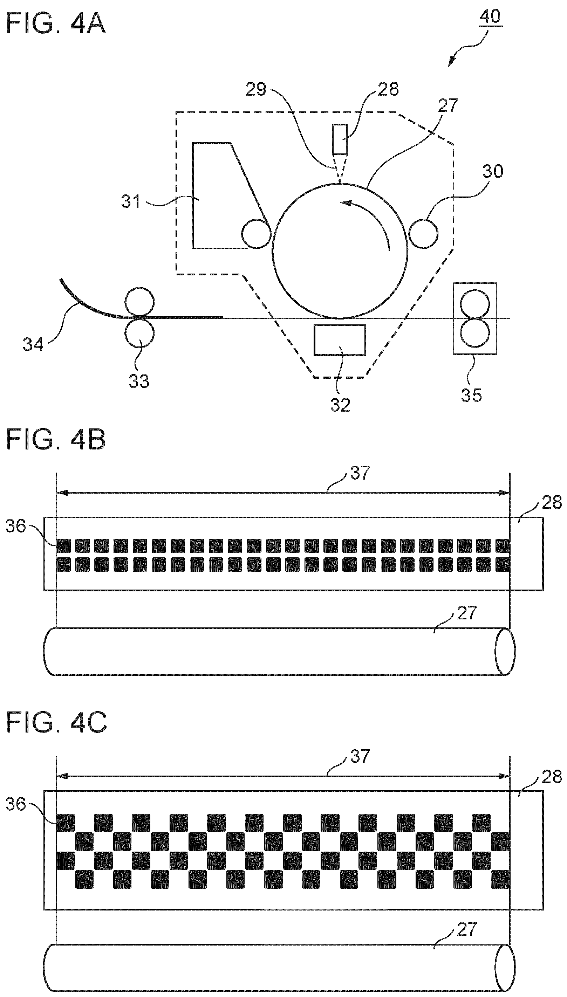

Figs. 4A to 4C illustrate an image-forming apparatus according to an embodiment of the present disclosure. Fig. 4A is a schematic view of an image-forming apparatus 40 according to an embodiment of the present disclosure. The image-forming apparatus includes a photosensitive member, an exposure light source, a developing unit, a charging unit, a transfer unit, a conveying roller, and a fixing unit.

An exposure light source 28 emits light 29, and an electrostatic latent image is formed on the surface of a photosensitive member 27. The exposure light source has an organic light-emitting element according to the present disclosure. A developing unit 31 contains toner and the like. The charging unit 30 electrifies the photosensitive member. A transfer unit 32 transfers a developed image onto a recording medium 34. A conveying unit 33 conveys the recording medium 34. The recording medium 34 is paper, for example. The fixing unit 35 fixes an image on the recording medium.

Figs. 4B and 4C are schematic views of a plurality of light-emitting portions 36 arranged on a long substrate in the exposure light source 28. 37 indicates a direction parallel to the axis of the photosensitive member and indicates a column direction in which the organic light-emitting elements are arranged. This column direction is the same as the direction of the rotation axis of the photosensitive member 27. This direction can also be referred to as the major-axis direction of the photosensitive member.

Fig. 4B illustrates the light-emitting portions arranged in the major-axis direction of the photosensitive member. Unlike Fig. 4B, Fig. 4C illustrates the light-emitting portions alternately arranged in the column direction in the first column and the second column. The first and second columns are arranged at different positions in the row direction.

In the first column, a plurality of light-emitting portions are arranged at intervals. The second column has light-emitting portions at positions corresponding to the intervals between the light-emitting portions of the first column. Thus, a plurality of light-emitting portions are arranged at intervals also in the row direction.

The arrangement in Fig. 4C can also be referred to as a grid-like pattern, a staggered pattern, or a checkered pattern, for example.

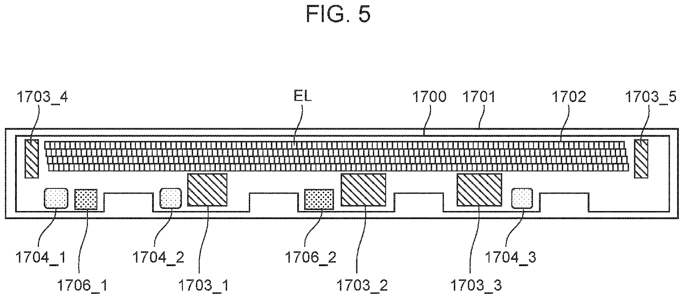

Fig. 5 is a schematic view of one form of a light-emitting device according to the present embodiment. The light-emitting device according to the present embodiment can be used, for example, as a light source for an image-forming apparatus. The light-emitting device according to the present embodiment has a rectangular shape with a long side parallel to a first direction and a short side parallel to a direction across the first direction. For example, the first direction may be a direction along a rotation axis direction of a photosensitive member of an image-forming apparatus.

A substrate 1701 has a polygonal shape, and an example of a rectangular substrate 1701 is described below. In the present specification, a long-side direction of the rectangular substrate 1701 is referred to as a first direction, and a short-side direction perpendicular to the long-side direction is referred to as a second direction. The polygonal shape in the present specification also includes a shape with rounded corners. A moisture-resistant ring 1700 is disposed on the rectangular substrate 1701 to suppress and prevent water from entering the light-emitting device. The moisture-resistant ring 1700 may be, for example, a guard ring composed of a wiring layer.

A light-emitting region 1702, a contact region 1703, a pad 1704, and a circuit 1706 are arranged inside the moisture-resistant ring 1700. In the present embodiment, the contact region 1703 includes a first contact region 1703_1, a second contact region 1703_2, and a third contact region 1703_3. The pad 1704 includes a first pad 1704_1, a second pad 1704_2, and a third pad 1704_3.

The circuit 1706 is part of a circuit for driving the light-emitting device, and specific examples thereof include, but are not limited to, an input protection circuit, an input circuit to which data for driving is input, and a logic circuit for processing data.

Light-emitting elements EL are arranged in rows and columns in the light-emitting region 1702. The contact region 1703 is a region where wiring electrically connected to the common electrode of the light-emitting elements EL is provided. The pad 1704_1 electrically connects the contact region 1703 to an external element.

The outer peripheral shape of the moisture-resistant ring 1700 may have a plurality of recesses. This portion can be used, for example, as an abutting region on which a rib, which is a portion of a mask for vapor deposition in a film-forming step, abuts.

As described above, each of the light-emitting elements EL arranged in a matrix in the light-emitting region 1702 is composed of a light-emitting layer and a first electrode and a second electrode that hold the light-emitting layer therebetween. In the present embodiment, an example is shown in which the first electrode is an independent electrode provided in each of the light-emitting elements EL, and the second electrode is a common electrode provided in common to the light-emitting elements EL.

For example, when the light-emitting elements EL are arranged in four rows in the light-emitting region 1702, as illustrated in Fig. 5, the initial position of the light-emitting elements EL in the first row may be shifted in the X direction by one forth the dimension of the light-emitting elements EL in the X direction from the initial position of the light-emitting elements EL in the second row. For n rows, where n is an integer of 2 or more, the initial position of the light-emitting elements EL in the first row may be shifted in the X direction by 1/n of the dimension of the light-emitting element EL in the X direction from the initial position of the light-emitting elements EL in the second row. Such a structure is advantageous for improving resolution.

The contact region 1703 is a region adjacent to the light-emitting region 1702 of the substrate 1701 and is arranged inside the moisture-resistant ring 1700. At least one of the first contact region 1703_1, the pad 1704, and the circuit 1706 may be disposed between the light-emitting region 1702 and one long-side end portion of the substrate 1701 together with the recesses of the moisture-resistant ring 1700 and may be arranged in series in the long-side direction.

Thus, when the contact region 1703, the pad 1704, the circuit 1706, and the like are provided at the same position in the short-side direction, this can reduce the length of the light-emitting device in the short-side direction and the size of the light-emitting device.

The light-emitting device according to the present embodiment has a plurality of contact regions 1703 between the common electrode of the light-emitting elements EL and power supply wiring along the long-side edge of the light-emitting device. When the common electrode is composed of, for example, a transparent electrode material with a relatively high electrical resistance, the voltage drop may increase in the major-axis direction. Thus, the voltage applied to each OLED varies with the distance from the contact region to which the electric potential is supplied. This may result in different actual luminous brightness between OLEDs to which a voltage for emitting light with the same brightness is applied, and cause shading or the like. A plurality of contact regions 1703 in the major-axis direction as in the present embodiment can reduce a voltage drop of the common electrode in the long-side direction and reduce the occurrence of shading or the like.

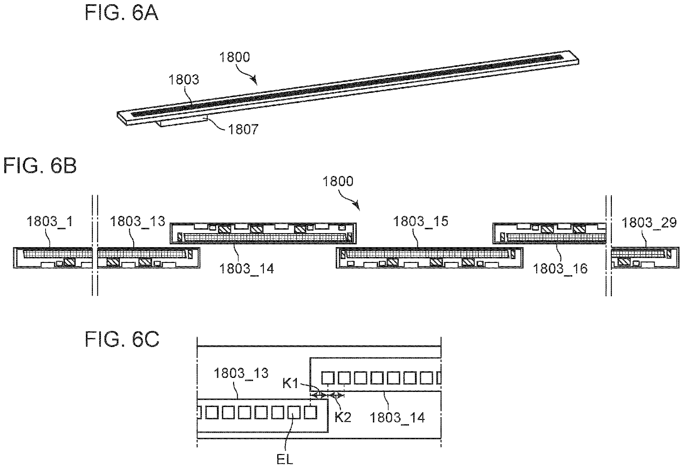

In the present embodiment, an example in which a light-emitting device is used for a head substrate 1800 of an exposure head of an image-forming apparatus is described below with reference to Figs. 6A to 6C.

Fig. 6A is a schematic perspective view of the head substrate 1800. Fig. 6B illustrates an arrangement of a plurality of light-emitting elements EL provided on the head substrate 1800, and Fig. 6C is a partial enlarged view of Fig. 6B.

An LED chip 1803 is mounted on the head substrate 1800. The LED chip 1803 can be, for example, the light-emitting device described in other embodiments.

As illustrated in Fig. 6A, the LED chip 1803 is provided on one surface of the head substrate 1800, and a long flexible flat cable (FFC) connector 1807 is provided on the other surface. The one surface of the head substrate 1800 is a surface (upper surface or front surface) on which the LED chip 1803 is provided. The other surface of the substrate is a surface (lower surface or back surface) opposite the side on which the LED chip 1803 is provided.

The FFC connector 1807 is attached to the other surface (lower surface or back surface) of the head substrate 1800 such that the longitudinal direction thereof is along the longitudinal direction of the head substrate 1800. The long FFC connector 1807 is provided for inputting a control signal (drive signal) from a control circuit portion of the main body of the image-forming apparatus, and the control signal is transferred to each LED chip 1803. The LED chip 1803 is driven (turned on and off) by a control signal input to the head substrate 1800.

The LED chip 1803 mounted on the head substrate 1800 is described below. As illustrated in Figs. 6B and 6C, a plurality of light-emitting elements EL are arranged on one surface of the head substrate 1800. For example, LED chips 1803_1 to 1803_29 (29 chips) are arranged. Fig. 6B illustrates the LED chips 1803_1, 1803_13, 1803_14, 1803_15, 1803_16, and 1803_29. In each of the LED chips 1803_1 to 1803_29, a plurality of light-emitting elements EL are arranged in the longitudinal direction, and, for example, 516 light-emitting elements EL are arranged.

In the longitudinal direction of the LED chip 1803, the center-to-center distance k2 between adjacent light-emitting elements EL corresponds to the resolution of the image-forming apparatus. For example, when the resolution of the image-forming apparatus according to the present embodiment is 1200 dpi, the light-emitting elements EL are arranged in the longitudinal direction of the LED chips 1803_1 to 1803_29 such that the center-to-center distance k2 between adjacent light-emitting elements EL is 21.16 µm. Thus, the exposure range of the exposure head of the present embodiment is approximately 314 mm.

A photosensitive layer of a photosensitive drum is formed at a width of 314 mm or more. The length of the long side of an A4-size recording paper and the length of the short side of an A3-size recording paper are 297 mm. The exposure head in the present embodiment therefore has an exposure range capable of forming an image on an A4-size recording paper and an A3-size recording paper. Although Figs. 6A to 6C illustrate an example in which a plurality of light-emitting elements EL are arranged in the longitudinal direction, the light-emitting elements EL may be arranged in the transverse direction in addition to the longitudinal direction.

The LED chips 1803_1 to 1803_29 are arranged in the axial direction of the photosensitive drum. More specifically, the LED chips 1803_1 to 1803_29 are alternately arranged in two rows in the axial direction of the photosensitive drum. More specifically, as illustrated in Fig. 6B, the odd-numbered LED chips 1803_1, 1803_3, ..., and 1803_29 counted from the left side are mounted in a line in the longitudinal direction of the substrate 1800. Furthermore, the even-numbered LED chips 1803_2, 1803_4, ..., and 1803_28 counted from the left side are mounted in a line in the longitudinal direction of the substrate 1800. The LED chips 1803 are arranged in this manner.

Thus, as illustrated in Fig. 6C, the center-to-center distance k1 between the light-emitting elements EL and the center-to-center distance k2 between the light-emitting elements EL can be made equal in the longitudinal direction of the LED chip 1803. The center-to-center distance k1 between the light-emitting elements EL indicates the center-to-center distance between the light-emitting elements EL arranged at one end of the LED chip 1803_13 and at the other end of the LED chip 1803_14. The center-to-center distance k2 between the light-emitting elements EL indicates the center-to-center distance k2 between adjacent light-emitting elements EL in the LED chip 1803_14.

Thus, the center-to-center distance k1 between adjacent light-emitting elements EL arranged at one end of one LED chip 1803 and at the other end of the other LED chip 1803 can be made equal to the center-to-center distance k2 between adjacent light-emitting elements EL on one LED chip 1803.

In the present embodiment, the light-emitting elements EL are organic light-emitting elements and are current-driven light-emitting elements. The organic light-emitting elements are arranged, for example, in a line in the main scanning direction (the axial direction of the photosensitive drum) on a thin film transistor (TFT) substrate and are electrically connected in parallel by power supply wiring provided in the main scanning direction.

When the light-emitting device is used in the exposure head, due to linear exposure, the ratio of the dimension in the longitudinal direction (a first direction X) to the dimension in the transverse direction (a second direction Y) of the light-emitting region 1702 is higher than when the light-emitting device is used in a display apparatus or the like. The ratio of the dimension in the longitudinal direction (the first direction X) to the dimension in the transverse direction (the third direction Y) of the substrate of the LED chip is also higher.

More specifically, for example, the length of the long side of the LED chip (or the light-emitting region 1702) is five times or more, possibly ten times or more, the length of the short side of the LED chip (or the light-emitting region 1702). For example, the length of the long side of the LED chip (or the light-emitting region 1702) can be 20 times or more the length of the short side of the LED chip (or the light-emitting region 1702).

The length of the long side of the LED chip is determined by the length of the photosensitive drum in the axial direction, the number of LED chips arranged in the axial direction, and the arrangement of the LED chips 1803. The length of the short side of the LED chip 1803 is determined depending on whether the light-emitting elements EL are disposed in the light-emitting region 1702 or the arrangement of the pad 1704 and the contact region 1703 in the direction perpendicular to the axis of the photosensitive drum.

An organic layer 66 may include a light-emitting layer that emits red light in consideration of the wavelength dependence of the photosensitivity of the photosensitive drum.

The LED chip 1803 may have a color filter. The color filter can improve print quality because it can absorb stray light from an unintended direction without reducing the normal amount of light incident on the photosensitive drum.

As described above, an apparatus including the organic light-emitting element according to the present embodiment can be used to stably display a highquality image for extended periods.

The present disclosure can provide an image-forming apparatus with high image formation efficiency.

While the present invention has been described with reference to exemplary embodiments, it is to be understood that the invention is not limited to the disclosed exemplary embodiments.

## Claims

1. An image-forming apparatus (40) comprising:
a light source including an organic light-emitting element (26) on a first surface of a substrate (11); and a photosensitive member (27) configured to receive light from the organic light-emitting element,
wherein the organic light-emitting element includes a first electrode (21), a first organic compound layer, a light-emitting layer, a second organic compound layer, and a second electrode (23) in this order from the first surface, and
a maximum emission peak wavelength in an emission spectrum (1) of the organic light-emitting element is closer to a wavelength of a maximum absorption value in a visible light region of an optical absorption spectrum (2) of the photosensitive member than a longest peak wavelength in an optical absorption spectrum (3, 5) of the first organic compound layer or a longest peak wavelength in an optical absorption spectrum (4, 6, 7) of the second organic compound layer.

2. The image-forming apparatus according to Claim 1, wherein the maximum emission peak wavelength in the emission spectrum of the organic light-emitting element is closer to a maximum absorption peak wavelength in the visible light region of the optical absorption spectrum of the photosensitive member than the longest peak wavelength in the optical absorption spectrum of the first organic compound layer and the longest peak wavelength in the optical absorption spectrum of the second organic compound layer.

3. The image-forming apparatus according to Claim 1, wherein
the first electrode is a reflective electrode, and the second electrode is a light extraction electrode, and
the second organic compound layer has a larger layer thickness than the first organic compound layer.

4. The image-forming apparatus according to Claim 3, wherein a longest-wavelength peak in the optical absorption spectrum of the second organic compound layer is farther from the maximum emission peak wavelength in the emission spectrum than a longest-wavelength peak in the optical absorption spectrum of the first organic compound layer.

5. The image-forming apparatus according to Claim 1, wherein
the first electrode is a reflective electrode, and the second electrode is a light extraction electrode, and
the first organic compound layer has a larger layer thickness than the second organic compound layer.

6. The image-forming apparatus according to Claim 5, wherein a longest-wavelength peak in the optical absorption spectrum of the first organic compound layer is farther from the maximum emission peak wavelength in the emission spectrum than a longest-wavelength peak in the optical absorption spectrum of the second organic compound layer.

7. The image-forming apparatus according to Claim 1, further comprising a third organic compound layer between the first organic compound layer and the first electrode.

8. The image-forming apparatus according to Claim 7, comprising a fourth organic compound layer between the second organic compound layer and the second electrode.

9. The image-forming apparatus according to Claim 1, wherein the first organic compound layer is composed only of an arylamine compound.

10. The image-forming apparatus according to Claim 1, wherein the second organic compound layer is composed only of an aromatic hydrocarbon compound.

11. The image-forming apparatus according to any one of Claims 1 to 10, wherein the first electrode and the second electrode constitute an optical resonator structure.

12. The image-forming apparatus according to any one of Claims 1 to 10, comprising
a reflective layer between the substrate and the first electrode,
wherein the reflective layer and the second electrode constitute an optical resonator structure.

13. The image-forming apparatus according to any one of Claims 1 to 10, wherein the substrate is a light-impermeable substrate.

14. The image-forming apparatus according to any one of Claims 1 to 10, wherein the substrate is a silicon substrate.

15. The image-forming apparatus according to Claim 14, wherein a transistor is provided on the silicon substrate, and the transistor is coupled to the organic light-emitting element.

## Patentansprüche

1. Bildbildende Vorrichtung (40), die aufweist:
eine Lichtquelle, die ein organisches lichtemittierendes Element (26) auf einer ersten Oberfläche eines Substrats (11) enthält; und ein fotosensitives Bauteil (27), das konfiguriert ist, Licht von dem organischen lichtemittierenden Element zu empfangen,
wobei das organische lichtemittierende Element eine erste Elektrode (21), eine erste organische Verbindungsschicht, eine lichtemittierende Schicht, eine zweite organische Verbindungsschicht, und eine zweite Elektrode (23) in dieser Reihenfolge von der ersten Oberfläche enthält, und
eine maximale Emissionspeakwellenlänge in einem Emissionsspektrum (1) des organischen lichtemittierenden Elements näher an einer Wellenlänge eines maximalen Absorptionswerts in einem sichtbaren Lichtbereich eines optischen Absorptionsspektrums (2) des fotosensitiven Bauteils als eine längste Peakwellenlänge in einem optischen Absorptionsspektrum (3, 5) der ersten organischen Verbindungsschicht oder einer längsten Peakwellenlänge in einem optischen Absorptionsspektrum (4, 6, 7) der zweiten organischen Verbindungsschicht ist.

2. Bildbildende Vorrichtung nach Anspruch 1, wobei die maximale Emissionspeakwellenlänge in dem Emissionsspektrum des organischen lichtemittierenden Elements näher an einer maximalen Absorptionspeakwellenlänge in dem sichtbaren Lichtbereich des optischen Absorptionsspektrums des fotosensitiven Bauteils als die längste Peakwellenlänge in dem optischen Absorptionsspektrum der ersten organischen Verbindungsschicht und die längste Peakwellenlänge in dem optischen Absorptionsspektrum der zweiten organischen Verbindungsschicht ist.

3. Bildbildende Vorrichtung nach Anspruch 1, wobei
die erste Elektrode eine reflektierende Elektrode ist und die zweite Elektrode eine Lichtextraktionselektrode ist, und
die zweite organische Verbindungsschicht eine größere Schichtdicke als die erste organische Verbindungsschicht aufweist.

4. Bildbildende Vorrichtung nach Anspruch 3, wobei ein längster Wellenlängenpeak in dem optischen Absorptionsspektrum der zweiten organischen Verbindungsschicht weiter von der maximalen Emissionspeakwellenlänge in dem Emissionsspektrum als ein längster Wellenlängenpeak in dem optischen Absorptionsspektrum der ersten organischen Verbindungsschicht entfernt ist.

5. Bildbildende Vorrichtung nach Anspruch 1, wobei
die erste Elektrode eine reflektierende Elektrode ist, und die zweite Elektrode eine Lichtextraktionselektrode ist, und
die erste organische Verbindungsschicht eine größere Schichtdicke als die zweite organische Verbindungsschicht aufweist.

6. Bildbildende Vorrichtung nach Anspruch 5, wobei ein längster Wellenlängenpeak in dem optischen Absorptionsspektrum der ersten organischen Verbindungsschicht weiter von der maximalen Emissionspeakwellenlänge in dem Emissionsspektrum als ein längster Wellenlängenpeak in dem optischen Absorptionsspektrum der zweiten organischen Verbindungsschicht entfernt ist.

7. Bildbildende Vorrichtung nach Anspruch 1, die ferner eine dritte organische Verbindungsschicht zwischen der ersten organischen Verbindungsschicht und der ersten Elektrode aufweist.

8. Bildbildende Vorrichtung nach Anspruch 7, die ferner eine vierte organische Verbindungsschicht zwischen der zweiten organischen Verbindungsschicht und der zweiten Elektrode aufweist.

9. Bildbildende Vorrichtung nach Anspruch 1, wobei die erste organische Verbindungsschicht nur aus einer Arylaminverbindung zusammengesetzt ist.

10. Bildbildende Vorrichtung nach Anspruch 1, wobei die zweite organische Verbindungsschicht nur aus einer aromatischen Kohlenwasserstoffverbindung zusammengesetzt ist.

11. Bildbildende Vorrichtung nach einem der Ansprüche 1 bis 10, wobei die erste Elektrode und die zweite Elektrode eine optische Resonatorstruktur bilden.

12. Bildbildende Vorrichtung nach einem der Ansprüche 1 bis 10, die aufweist:
eine reflektierende Schicht zwischen dem Substrat und der ersten Elektrode,
wobei die reflektierende Schicht und die zweite Elektrode eine optische Resonatorstruktur bilden.

13. Bildbildende Vorrichtung nach einem der Ansprüche 1 bis 10, wobei das Substrat ein lichtundurchlässiges Substrat ist.

14. Bildbildende Vorrichtung nach einem der Ansprüche 1 bis 10, wobei das Substrat ein Siliziumsubstrat ist.

15. Bildbildende Vorrichtung nach Anspruch 14, wobei ein Transistor auf dem Siliziumsubstrat bereitgestellt ist, und der Transistor mit dem organischen lichtemittierenden Element gekoppelt ist.

## Revendications

1. Appareil de formation d'image (40) comprenant :
une source de lumière comportant un élément émetteur de lumière organique (26) sur une première surface d'un substrat (11) ; et un organe photosensible (27) configuré pour recevoir de la lumière de l'élément émetteur de lumière organique,
dans lequel l'élément émetteur de lumière organique comporte une première électrode (21), une première couche de composé organique, une couche émettrice de lumière, une deuxième couche de composé organique, et une seconde électrode (23) dans cet ordre à partir de la première surface, et
une longueur d'onde de pic d'émission maximale dans un spectre d'émission (1) de l'élément émetteur de lumière organique est plus proche d'une longueur d'onde d'une valeur d'absorption maximale dans une région de lumière visible d'un spectre d'absorption optique (2) de l'organe photosensible qu'une longueur d'onde de pic la plus longue dans un spectre d'absorption optique (3, 5) de la première couche de composé organique ou qu'une longueur d'onde de pic la plus longue dans un spectre d'absorption optique (4, 6, 7) de la deuxième couche de composé organique.

2. Appareil de formation d'image selon la revendication 1, dans lequel la longueur d'onde de pic d'émission maximale dans le spectre d'émission de l'élément émetteur de lumière organique est plus proche d'une longueur d'onde de pic d'absorption maximale dans la région de lumière visible du spectre d'absorption optique de l'organe photosensible que la longueur d'onde de pic la plus longue dans le spectre d'absorption optique de la première couche de composé organique et que la longueur d'onde de pic la plus longue dans le spectre d'absorption optique de la deuxième couche de composé organique.

3. Appareil de formation d'image selon la revendication 1, dans lequel
la première électrode est une électrode réfléchissante, et la seconde électrode est une électrode d'extraction de lumière, et
la deuxième couche de composé organique présente une épaisseur de couche plus importante que la première couche de composé organique.

4. Appareil de formation d'image selon la revendication 3, dans lequel un pic de longueur d'onde la plus longue dans le spectre d'absorption optique de la deuxième couche de composé organique est plus éloigné de la longueur d'onde de pic d'émission maximale dans le spectre d'émission qu'un pic de longueur d'onde la plus longue dans le spectre d'absorption optique de la première couche de composé organique.

5. Appareil de formation d'image selon la revendication 1, dans lequel
la première électrode est une électrode réfléchissante, et la seconde électrode est une électrode d'extraction de lumière, et
la première couche de composé organique présente une épaisseur de couche plus importante que la deuxième couche de composé organique.

6. Appareil de formation d'image selon la revendication 5, dans lequel un pic de longueur d'onde la plus longue dans le spectre d'absorption optique de la première couche de composé organique est plus éloigné de la longueur d'onde de pic d'émission maximale dans le spectre d'émission qu'un pic de longueur d'onde la plus longue dans le spectre d'absorption optique de la deuxième couche de composé organique.

7. Appareil de formation d'image selon la revendication 1, comprenant en outre une troisième couche de composé organique entre la première couche de composé organique et la première électrode.

8. Appareil de formation d'image selon la revendication 7, comprenant une quatrième couche de composé organique entre la deuxième couche de composé organique et la seconde électrode.

9. Appareil de formation d'image selon la revendication 1, dans lequel la première couche de composé organique est composée uniquement d'un composé arylamine.

10. Appareil de formation d'image selon la revendication 1, dans lequel la deuxième couche de composé organique est composée uniquement d'un composé hydrocarboné aromatique.

11. Appareil de formation d'image selon l'une quelconque des revendications 1 à 10, dans lequel la première électrode et la seconde électrode constituent une structure de résonateur optique.

12. Appareil de formation d'image selon l'une quelconque des revendications 1 à 10, comprenant
une couche réfléchissante entre le substrat et la première électrode,
dans lequel la couche réfléchissante et la seconde électrode constituent une structure de résonateur optique.

13. Appareil de formation d'image selon l'une quelconque des revendications 1 à 10, dans lequel le substrat est un substrat imperméable à la lumière.

14. Appareil de formation d'image selon l'une quelconque des revendications 1 à 10, dans lequel le substrat est un substrat de silicium.

15. Appareil de formation d'image selon la revendication 14, dans lequel un transistor est prévu sur le substrat de silicium, et le transistor est couplé à l'élément émetteur de lumière organique.
